# FASCICULE DE BREVET EUROPEEN

(11) **EP 4 062 401 B1**
(45) Date de publication et mention de la délivrance du brevet: **16.08.2023**
(21) Numéro de dépôt: 20808180.2
(22) Date de dépôt: 26.10.2020
(51) Int. Cl.: G10L 15/20, H04R 3/00, H03G 3/02, G10L 15/32, G10L 15/08, G10L 21/0316, B60R 16/037

(54) **DISPOSITIF POUR METTRE EN OEUVRE UN ASSISTANT PERSONNEL VIRTUEL DANS UN VÉHICULE AUTOMOBILE AVEC CONTRÔLE PAR LA VOIX D'UN UTILISATEUR, ET VÉHICULE AUTOMOBILE L'INCORPORANT**
VORRICHTUNG ZUR IMPLEMENTIERUNG EINES VIRTUELLEN PERSÖNLICHEN ASSISTENTEN IN EINEM KRAFTFAHRZEUG MIT BENUTZERSPRACHSTEUERUNG UND KRAFTFAHRZEUG DAMIT
DEVICE FOR IMPLEMENTING A VIRTUAL PERSONAL ASSISTANT IN A MOTOR VEHICLE WITH USER VOICE CONTROL, AND MOTOR VEHICLE INCORPORATING SAME

(30) Priorité: 21.11.2019 FR 1913004
(43) Date de publication de la demande: 28.09.2022
(73) Titulaire: PSA Automobiles SA, 78300 Poissy (FR)
(72) Inventeur: BARAKAT, Fatimazahra, 92800 PUTEAUX (FR)
(86) Numéro de dépôt international: PCT/FR2020/051927
(87) Numéro de publication internationale: WO 2021/099707

(56) Documents cités:
- WO-A1-2019/187371
- CN-A- 110 033 773
- US-A1- 2013 325 458

## Description

### Domaine technique

La présente invention se rapporte de manière générale au traitement d'un signal audio capté dans un véhicule automobile, et plus particulièrement à un dispositif d'activation d'un assistant personnel virtuel embarqué dans un véhicule automobile, par la voix d'un utilisateur.

### Etat de la technique

Les assistants personnels virtuels (APV) ou assistants personnels intelligents (API) sont des dispositifs essentiellement logiciels qui permettent d'exécuter des tâches ou de fournir des services spécifiques à leurs utilisateurs. Ils utilisent pour cela des informations telles que le contexte de leur utilisation (le lieu, la date, etc.), un profil d'utilisateur (son identité, un historique de son usage antérieur, etc.) et des données d'entrée fournies par l'utilisateur (i.e., des commandes et/ou requêtes spécifiques). Ils permettent ainsi de fournir à chaque utilisateur une assistance pertinente et personnalisée pour l'utilisation d'un appareil, pour la réalisation de certaines tâches, pour obtenir de l'information utile, etc.

Ces APV sont typiquement intégrés à des équipements dits équipements intelligents (« *Smart device* » en anglais) tels que les appareils nomades et communicants comme les smartphones ou les tablettes, ou d'autres appareils connectés, que ce soit pour un usage domestique (à la maison), dans un véhicule, ou en nomade, par exemple. Dans tous les cas, ils sont exécutés par une unité de traitement (*i.e.,* un calculateur) de l'équipement intelligent dans lequel ils sont intégrés.

Pour les applications dans lesquelles l'APV est utilisé à bord d'un véhicule, cette unité de traitement peut être embarquée, en tout ou en partie, c'est-à-dire qu'il peut s'agir d'un calculateur du véhicule automobile. Tout du moins, une partie des traitements peut être effectuée dans un tel calculateur. En variante, l'unité de traitement peut aussi être débarquée, c'est-à-dire qu'elle peut être comprise dans un appareil distinct du véhicule, comme un appareil nomade et communicant d'un utilisateur, du type de ceux envisagés dans le paragraphe ci-dessus, par exemple. Dans ce cas, l'appareil peut être adapté pour contrôler des fonctionnalités du véhicule afin par exemple, de permettre le réglage de paramètres de confort (la température à bord, le niveau sonore restitué par une installation multimédia embarquée, et.) ou de piloter le fonctionnement de certains équipements du véhicule (par l'exemple l'ouverture des fenêtres électriques, l'allumage des phares, etc.).

L'utilisateur peut contrôler un APV physiquement par l'intermédiaire d'un dispositif d'interface homme/machine de l'équipement intelligent auquel l'APV est intégré. Par exemple, l'APV peut être activé par l'appui sur un bouton dédié d'un boîtier, sur une touche ou une combinaison de touches d'un clavier physique ou virtuel, ou sur un bouton virtuel sur un écran tactile, par exemple. Cependant, pour rendre leur utilisation plus ergonomique, la plupart des APV récents peuvent aussi être contrôlés vocalement, c'est-à-dire par la voix de l'utilisateur. Par « contrôlé vocalement » on entend à la fois le fait d'être activé à partir d'un état de veille (« *Standby mode* » en anglais) et le fait, en outre, d'être commandé par l'intermédiaire de commandes ou de requêtes exprimées oralement par l'utilisateur. Une fonction de reconnaissance vocale (ou ASR mis pour « *Automatic Speech Recognition* », en anglais, ou encore VRE mis pour « *Voice Recognition Engine »,* en anglais) est alors couplée à l'APV. Elle s'exécute sur l'unité de traitement de l'équipement intelligent qui intègre l'APV, et permet de reconnaître des mots prononcés par un utilisateur. Une séquence de mots reconnus peut alors être traitée par l'APV, qui les analyse pour en déduire la commande ou la requête exprimée par l'utilisateur, et pour exécuter ensuite la tâche ou le service correspondant.

Un tel contrôle vocal d'un APV est particulièrement utile à bord d'un véhicule automobile, où l'aspect « mains libres » est favorable à la sécurité. Le conducteur peut en effet activer une fonctionnalité ou un service sans utiliser ses mains qui demeurent donc libres pour la conduite, et sans devoir détourner le regard de la route en sorte que sa vigilance est peu affectée. Ainsi, un véhicule automobile peut embarquer un APV qui peut être exécuté par le processeur principal (ou mCPU, de l'anglais « *main Central Processing Unit* ») d'un calculateur embarqué du véhicule (ou ECU, de l'anglais « *Electronic Central Unit* »). Il peut s'agir par exemple du calculateur qui gère l'info-divertissement à bord du véhicule (ou IVI, de l'anglais « *In-Vehicle Infotainment* »). Un tel calculateur offre une plateforme matérielle et logicielle, dont l'architecture est adaptée pour la gestion des aspects média (radio, musique, vidéo, etc.) et des aspects communication (téléphonie, connexion à l'Internet, Bluetooth, etc.) dans le véhicule.

L'APV peut être contrôlé par l'intermédiaire d'un dispositif d'interface homme/machine (IHM) du véhicule, comprenant des boutons du tableau de bord, et/ou un clavier virtuel d'un écran tactile de l'ordinateur de bord, par exemple. En variante ou en complément, l'APV peut aussi être contrôlé vocalement, c'est-à-dire par la voix d'un utilisateur captée par un ou plusieurs microphones disposés dans l'habitacle du véhicule. A cet effet, une fonction de reconnaissance vocale peut être exécutée en permanence par le processeur principal du calculateur, dès lors qu'un microphone est activé pour permettre de capter la voix d'un utilisateur présent à bord du véhicule. Plus particulièrement, un moteur de reconnaissance vocale (ou moteur ASR) est un module de nature logicielle qui peut être exécuté par le processeur principal du calculateur.

Afin de permettre l'activation de l'APV en réponse à une commande vocale prononcée par un utilisateur, le moteur de reconnaissance vocale peut mettre en oeuvre une fonction de détection d'un mot-clé d'activation, aussi appelé mot de réveil (ou Wuw, mis pour « *Wake-up word* » en anglais). Cette fonction de détection du mot-clé d'activation est adaptée pour activer l'APV dès qu'elle reconnaît un ou plusieurs mots-clés d'activation prédéfinis. Dans le domaine des APV domestiques du marché ou dans le domaine des smartphones, on connaît par exemple les mots-clés ou séquences de mots-clés suivants : « Ok Google », « Siri » ou « Alexa » pour les APV proposés par Google Assistant^{®}, Apple^{®} et Amazon^{®}, respectivement. Dès qu'un tel mot-clé d'activation est reconnu, l'APV concerné peut être activé et la séquence de mots à laquelle le mot-clé appartient peut alors être traitée par le moteur de reconnaissance vocale pour en déduire, le cas échéant, une commande ou une requête correspondante de l'utilisateur. Cette commande ou cette requête est alors traitée par l'APV.

Un moteur de détection de mot-clé d'activation (ou moteur de Wuw) est spécialement adapté pour permettre, à partir d'un signal audio capté par un ou plusieurs microphones, d'identifier la prononciation d'un mot-clé d'activation par l'un quelconque des utilisateurs qui sont assis à des positions respectives dans le véhicule.

Afin d'améliorer l'efficacité de la détection du mot-clé d'activation, et d'une manière générale les performances de l'activation de l'assistant personnel, un dispositif de détection du mot-clé d'activation de l'assistant personnel comprend un traitement spécifique, à savoir un algorithme de commande automatique de gain (ou AGC, de l'anglais « *Automatic Gain Control* »). Cet algorithme de traitement spécifique permet d'augmenter le succès de la détection du mot-clé d'activation par le moteur de Wuw, et tout à la fois de minimiser les fausses détections du mot-clé d'activation. De manière connue en soi, cet algorithme s'adapte en temps réel au signal en cours de traitement. Mais les seuils minimum et maximum de cet algorithme sont difficiles à fixer à l'avance à des valeurs potentiellement adaptées à la prononciation du mot-clé d'activation de l'assistant personnel par n'importe quel utilisateur, d'une part, et l'algorithme peut prendre un certain temps à converger, en sorte que le début du signal audio détecté n'est pas traité de manière optimale, d'autre part. Or, c'est justement le mot-clé d'activation qui est prononcé au début de chaque séquence audio détectée dans le véhicule.

On peut ainsi avoir un dispositif d'activation qui est :
- soit trop « sourd », c'est-à-dire qu'il présente beaucoup de « faux négatifs », un utilisateur prononçant le mot-clé d'activation mais celui-ci n'étant pas reconnu car le seuil minimum est trop élevé ;
- soit trop « éveillé », c'est-à-dire qu'il présente beaucoup de « faux positifs », en ce sens que l'assistant personnel réagit même si l'utilisateur ne l'a pas sollicité.

Le document WO 2019/187371 A1 traite de la détection de mot-clés au sein de l'habitacle d'un véhicule équipé de plusieurs microphones.

Le document US 20190147875 décrit un mécanisme d'adaptation de la reconnaissance vocale, qui peut mettre à jour l'ACG à partir d'informations venant du cloud.

Le document EP 3183727 décrit un système et un procédé permettant de valider un mot-clé d'activation. Dans le paragraphe [0038], il est question de paramétrage du mécanisme de détection mais aucun mode de réalisation n'est décrit en détail.

Enfin, le document US 20130304475 décrit un mécanisme de paramétrage spécifique d'un système de reconnaissance vocale, suivant que le toit du véhicule est ouvert ou non (ou qu'un véhicule décapotable est décapoté ou non).

### Résumé de l'invention

L'invention permet d'adapter la sensibilité de la reconnaissance du mot-clé d'activation d'un assisant personnel virtuel (APV) embarqué dans un véhicule automobile en fonction d'un paramétrage spécifique lié à l'utilisateur identifié, et ainsi d'améliorer les performances de la détection du mot-clé d'activation prononcé par un utilisateur quelconque du véhicule. L'invention part en effet du constat qu'un véhicule automobile est potentiellement multi-utilisateur, mais que les utilisateurs sont souvent les membres d'un même groupe (typiquement une même famille) et que ces membres peuvent avoir un profil d'utilisateur enregistré dans le véhicule. Il est donc possible de personnaliser certains réglages de la chaîne de traitement d'une manière qui soit propre à un utilisateur déterminé, identifié parmi une pluralité d'utilisateurs potentiels ayant chacun un profil d'utilisateur mémorisé dans le véhicule ou dans le cloud, par exemple.

A cet effet, l'invention propose un dispositif pour la détection d'un mot-clé d'activation d'un assistant personnel virtuel embarqué dans un véhicule automobile et activable par la voix d'un utilisateur, comprenant :
- un nombre *m* de microphones, où *m* est un nombre entier supérieur ou égal à l'unité, agencés dans l'habitacle du véhicule automobile et adaptés pour capter *m* signaux audios respectifs ;
- *m* modules de détection du mot-clé d'activation comprenant chacun un dispositif de commande automatique de gain, et adaptés pour exécuter en parallèle chacun un moteur de détection du mot-clé d'activation de l'assistant personnel virtuel, lesdits moteurs de détection étant appliqués à chacun, respectivement, des *m* signaux audios captés par les *m* microphones, respectivement ;
- un module d'identification d'utilisateur adapté pour identifier un utilisateur présent dans le véhicule ; et,
- un module de calibration adapté pour calibrer les dispositifs de commande automatique de gain des modules de détection du mot-clé d'activation avec des valeurs respectives d'un nombre *p* de paramètres de fonctionnement desdits dispositifs, où *p* est un nombre entier supérieur ou égal à l'unité, lesdites valeurs étant fonction de l'utilisateur identifié par le module d'identification.

Ainsi, grâce à l'invention la sensibilité du dispositif de détection du mot-clé d'activation peut résulter de paramètres appartenant au profil d'utilisateur de l'utilisateur identifié. La détection du mot-clé d'activation de l'APV s'en trouve améliorée.

Des modes de réalisation pris isolément ou en combinaison, prévoient en outre que :
- les paramètres de fonctionnement des dispositifs de commande automatique de gain des modules de détection du mot-clé d'activation peuvent comprendre un seuil minimum et/ou un seuil maximum de la sensibilité de la détection de la voix par les modules de détection du mot-clé d'activation ;
- des valeurs des paramètres de fonctionnement des dispositifs de commande automatique de gain des modules de détection du mot-clé d'activation peuvent appartenir, pour chacun parmi un ou plusieurs utilisateurs potentiels du véhicule, à un profil d'utilisateur associé audit utilisateur potentiel ;

- un profil d'utilisateur d'un utilisateur potentiel du véhicule peut être stocké dans une mémoire électronique installée dans le véhicule ;
- un profil d'utilisateur d'un utilisateur potentiel du véhicule peut être stocké dans le cloud ;
- le module d'identification d'utilisateur peut être adapté pour identifier un utilisateur présent dans le véhicule sur la base de :
   -- la connexion au véhicule d'un appareil électronique personnel associé à l'utilisateur, via un dispositif d'interface du véhicule ;
   -- une information biométrique associée à l'utilisateur, obtenue par un capteur biométrique du véhicule ; et/ou,
   -- un identifiant saisi par l'utilisateur via une interface homme/machine du véhicule ;
   - le module d'identification d'utilisateur peut être adapté pour identifier un utilisateur présent dans le véhicule à l'origine de la commande vocale, par analyse de tout ou partie des *m* signaux audios captés par les ₘ microphones, sur la base d'empreintes vocales stockées en mémoire en relation avec des profils d'utilisateurs associés à des utilisateurs potentiels du véhicule.

Un deuxième aspect de l'invention se rapporte à un procédé de détection d'un mot-clé d'activation d'un assistant personnel virtuel embarqué dans un véhicule automobile et activable par la voix d'un utilisateur, comprenant les étapes consistant à :
- capter un nombre *m* de signaux audios respectifs, où *m* est un nombre entier supérieur ou égal à l'unité, à l'aide de *m* microphones agencés dans l'habitacle du véhicule automobile ;
- exécuter en parallèle *m* moteurs de détection d'un mot-clé d'activation de l'assistant personnel virtuel appliqués à chacun, respectivement, des *m* signaux audios captés par les *m* microphones, respectivement, à l'aide de *m* modules de détection du mot-clé d'activation comprenant chacun un dispositif de commande automatique de gain ;

- identifier un utilisateur présent dans le véhicule ; et,
- calibrer les dispositifs de commande automatique de gain des modules de détection du mot-clé d'activation avec des valeurs respectives d'un nombre *p* de paramètres de fonctionnement desdits dispositifs, où *p* est un nombre entier supérieur ou égal à l'unité, lesdites valeurs étant fonction de l'utilisateur identifié.

Dans un troisième aspect, l'invention concerne également un calculateur de véhicule automobile comprenant un processeur principal et un processeur de signal numérique, configuré pour mettre en oeuvre le dispositif selon le premier aspect ci-dessus. Il peut s'agir, comme évoqué *supra,* du calculateur qui gère l'info-divertissement à bord du véhicule (ou IVI, de l'anglais « *In-Vehicle Infotainment* »), qui gère les aspects média et les aspects communication dans le véhicule.

Un quatrième et dernier aspect de l'invention se rapporte à un véhicule automobile comprenant un calculateur selon le troisième aspect ci-dessus.

### Brève description des figures

D'autres caractéristiques et avantages de l'invention apparaîtront encore à la lecture de la description qui va suivre. Celle-ci est purement illustrative et doit être lue en regard des dessins annexés sur lesquels :
**[****Fig. 1****]** la figure 1 est une représentation schématique d'un contexte d'usage dans lequel la détection d'un mot-clé d'activation peut être mise en oeuvre ;
**[****Fig. 2****]** la figure 2 est une représentation symbolique d'un dispositif de commande automatique de gain ;
**[****Fig. 3****]** la figure 3 est un graphe donnant l'allure de la réponse du dispositif de commande automatique de gain de la figure 2 ;
**[****Fig. 4****]** la figure 4 est un schéma fonctionnel d'un dispositif selon un mode de réalisation ; et,
**[****Fig. 5****]** la figure 5 est un schéma fonctionnel d'un dispositif selon un autre mode de réalisation.

### Description des modes de réalisation

Dans la description de modes de réalisation qui va suivre et dans les Figures des dessins annexés, les mêmes éléments ou des éléments similaires portent les mêmes références numériques aux dessins.

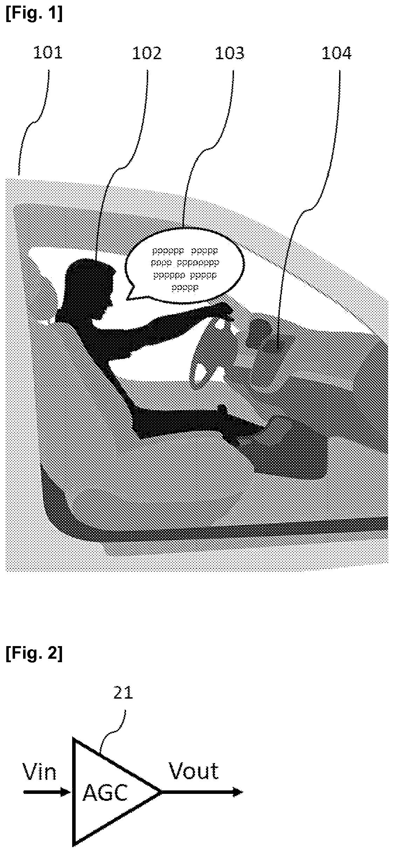

La **figure 1** illustre schématiquement le contexte d'un cas d'usage dans lequel on peut mettre en oeuvre un dispositif selon l'invention, pour la détection d'un mot-clé d'activation dans un signal audio capté par un microphone agencé dans l'habitacle d'un véhicule automobile. L'homme du métier appréciera que le contexte considéré n'est pas exclusif d'autres cas d'usage dans lesquels un tel dispositif peut aussi être mis en oeuvre.

En référence à la **figure 1****,** le véhicule 101 intègre un assistant personnel virtuel (APV) embarqué 104. L'APV embarqué 104 est par exemple commandé par la voix (*i*.*e*., la parole) d'un utilisateur 102 du véhicule, et/ou par d'autres moyens comme des boutons de commande, un clavier physique, un clavier virtuel affiché sur un écran tactile, etc. formant une interface homme/machine (IHM). L'utilisateur 102 représenté ici est le conducteur du véhicule 101. Toutefois, il peut aussi s'agir de l'un des passagers : soit un passager assis à l'avant à côté du conducteur, soit un passager assis à l'arrière en deuxième rang, ou bien en troisième rang pour les véhicules équipés de plus d'un rang de sièges arrière pour les passagers, comme les grands monospaces. De tels véhicules sont souvent prévus pour transporter sept personnes : le conducteur et le passager avant, en premier rang ; trois passagers arrière, en deuxième rang ; et enfin deux autres passagers arrière en troisième rang.

Dans le contexte d'usage considéré, l'utilisateur 102 prononce un mot ou une séquence de mots 103 qui sont reconnus par l'APV 104 et sont convertis en une (ou plusieurs) instruction(s) exécutable(s), et/ou une (ou plusieurs) requête(s) d'information à laquelle(auxquelles) l'APV doit apporter une réponse.

La séquence de mots 103 commence par un mot-clé d'activation, qui est adapté pour réveiller l'APV embarqué 104. En effet, pour des raisons d'économie d'énergie, les moyens matériels et logiciels mettant en oeuvre l'APV sont mis en sommeil (en « standby ») pendant les phases de non-utilisation prolongée. Et ils sont réveillés lorsque le mot-clé d'activation est prononcé par un utilisateur dans l'habitacle du véhicule, et est identifié par un dispositif d'identification dans un signal audio capté par un (ou plusieurs) microphone(s) qui est(sont) disposé(s) dans l'habitable. Le reste de la séquence de mots 103 est alors traité par l'APV afin d'identifier les instructions et/ou les requêtes qu'elle comprend.

Cet exemple n'est pas limitatif et l'homme du métier appréciera qu'un tel APV peut aussi être commandé, en variante ou en complément, par des commandes physiques entrée via l'IHM plutôt que par des commandes ou requêtes vocales. On notera que l'invention peut aussi être mise en oeuvre dans un système embarqué autre qu'un APV, pour lequel une activation vocale avec détection d'un mot-clé d'activation est utilisée. De manière générale, un tel système comprend une interface homme/machine (IHM) qui permet à tout utilisateur du véhicule de le commander. L'IHM comprend a *minima* un microphone qui capte les sons à l'intérieur de l'habitacle, et notamment un signal audio comprenant le mot-clé d'activation lorsqu'il est prononcé par un utilisateur présent à bord du véhicule.

Le dispositif d'identification du mot-clé d'activation de l'APV comprend une architecture de traitement audio qui est destinée à, et adaptée pour traiter un tel signal afin de détecter le mot-clé d'activation dans le signal. L'IHM peut aussi comprendre un écran tactile accessible au conducteur, qui permet en outre la saisie de commandes et/ou de paramètres, la sélection de commande présélectionnées, la navigation dans des menus, etc. En d'autres termes, le signal audio peut se résumer à un mot-clé d'activation prononcé par l'utilisateur mais comprend généralement, en outre, des commandes ou requêtes vocales qui sont prononcées à la suite du mot-clé d'activation. La commande vocale d'un dispositif embarqué comme l'APV embarqué 104 présente l'avantage d'éviter de trop perturber le conducteur pendant la conduite.

L'APV embarqué 104 fait partie d'un système qui comprend aussi des moyens audios de restitution d'une information sous la forme d'un message vocal, c'est-à-dire un message audio imitant, *i.e.,* synthétisant, la voix d'un opérateur. Dans un cas d'usage typique, en réponse à une requête vocale de l'utilisateur 102 du véhicule 101, le système émet un message vocal contenant des informations utiles destinées à l'utilisateur 102. En outre, dans d'autres modes de réalisation, le système peut comprendre des moyens visuels de restitution d'une information qui peuvent compléter l'émission de messages vocaux. Par exemple, le système peut intégrer un écran sur lequel sont affichées les informations utiles destinées à l'utilisateur du véhicule. Avantageusement, une telle restitution permet de transmettre une information intelligible pour l'utilisateur dans un environnement très bruyant.

Selon les modes de réalisation de l'invention, et afin d'optimiser le fonctionnement de l'activation de l'assistant personnel par mot-clé, la chaîne de traitement de signaux audio détectés par un ou plusieurs microphones dans l'habitacle du véhicule, comprend un traitement spécifique, à savoir un algorithme de commande automatique de gain (CAG, ou AGC de l'anglais « *Automatic Gain Control* »). Cet algorithme de traitement spécifique permet et d'augmenter le succès de la détection de du moteur de « *wake up word* », et tout à la fois de minimiser les fausses détections du mot-clé d'activation Wuw. Cet algorithme s'adapte en temps réel.

La **figure 2** montre la représentation schématique d'un dispositif 21 de commande automatique de gain (CAG, ou AGC en anglais). D'un point de vue fonctionnel, ce dispositif est équivalent à un amplificateur à gain variable, associé à un algorithme auto-adaptatif qui détermine la valeur du gain de l'amplificateur dans une plage de fonctionnement opérationnel qui est paramétrable. Cette plage de fonctionnement opérationnel correspond au domaine de variation du signal d'entrée Vin du dispositif 21, aussi appelé intervalle dynamique d'entrée du dispositif. Si l'on considère que le signal Vin est un signal audio capté par un microphone dans le véhicule automobile (qui peut être porté par une tension, par exemple), et que ce signal peut contenir la voix d'un utilisateur présent à bord du véhicule, l'intervalle dynamique d'entrée de ce signal Vin doit être paramétré pour correspondre à l'intervalle dynamique de la voix de l'utilisateur, c'est-à-dire au domaine de variation de l'intensité de la voix de l'utilisateur reflété par le signal audio capté. Ainsi, le domaine de variation du signal de sortie Vout (qui peut lui aussi être porté par une tension, par exemple) est contenu dans un intervalle dynamique attendu, ce qui améliore les performances du décodage de la parole. Comme on l'aura compris, c'est le rôle du dispositif de commande automatique de gain 21 que d'assurer cette mise en correspondance. A cet effet, l'algorithme auto-adaptatif est adapté pour modifier la réponse du dispositif 21 en fonction des variations observées du signal audio admis en entrée du dispositif.

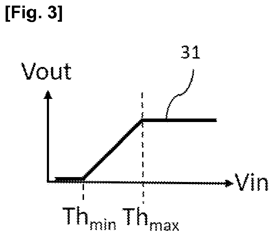

La réponse du dispositif de commande automatique de gain 21 est donnée par le graphe de la **figure 3****.** En référence à ce graphe, on fait l'hypothèse pour simplifier l'exposé d'une réponse linéaire entre deux seuils Thₘᵢₙ et Thₘₐₓ.

Le premier seuil Thₘᵢₙ correspond au seuil de sensibilité minimale de l'amplificateur, c'est-à-dire la valeur minimum du signal Vin en entrée qui donne un signal Vout visible en sortie. Le second seuil Thₘᵢₙ correspond au seuil de sensibilité maximale de l'amplificateur, c'est-à-dire la valeur maximum du signal d'entrée Vin qui produit une modification du signal de sortie Vout. Dit autrement, au-dessus du second seuil Thₘₐₓ, la puissance du signal de sortie Vout reste constante quelle que soit la puissance du signal d'entrée Vin. Dans l'exemple représenté, la réponse de l'amplificateur est par exemple linéaire entre les deux valeurs de seuil Thₘᵢₙ et Thₘₐₓ, ainsi qu'il a été dit plus haut. Dit autrement, le gain de l'amplificateur est constant pour des valeurs du signal d'entrée Vin qui sont comprises entre ces deux valeurs Thₘᵢₙ et Thₘₐₓ. Ceci n'est toutefois qu'un exemple, des réponses plus complexes pouvant être préférées en fonction des spécificités propres à chaque application.

Le gain de l'amplificateur est généralement exprimé en décibel (dB), qui est une unité sans dimension propre, utilisée pour quantifier le rapport entre deux valeurs. Dans le contexte de l'amplificateur 21 de la figure 2, il s'agit du rapport de la valeur du signal de sortie Vout sur la valeur du signal d'entrée Vin de l'amplificateur. Cette unité est commode pour exprimer, sur une échelle logarithmique, des valeurs qui présentent une grande amplitude. Dans un exemple, le gain de l'amplificateur 21 est par exemple égal à 20 dB pour les valeurs du signal d'entrée Vin comprises entre le seuil Thₘᵢₙ et le seuil Thₘₐₓ. Les valeurs de seuil Thₘᵢₙ et Thₘₐₓ peuvent être exprimées sous la forme de valeurs de tension en microvolts (µV) ou millivolts (mV), ou bien sous la forme de valeur de puissance en dBm ou en dBu. Les niveaux de signal basés sur des tensions mesurées sont en effet généralement exprimés sous la forme d'une valeur en dBm ou dB(mW), c'est-à-dire le rapport de la puissance développée par la tension sur une valeur de puissance unitaire égale à 1 milliwatt (1 mW). Comme cette unité est référencée par rapport au milliwatt, c'est une unité de mesure absolue :
- zéro dBm équivaut à un milliwatt ;
- une augmentation de 3 dB correspond approximativement à doubler la puissance, ce qui signifie que 3 dBm équivalent à environ 2 mW ;
- inversement, pour une diminution de 3 dB, la puissance est réduite de moitié environ, ce qui fait que -3 dBm correspond à environ 0,5 mW.

On notera que les normes ISO et CEI n'autorisent que la notation complète et sans ambiguïté « x dB *re* 1 mW » dans les publications techniques scientifiques. Par contre, les normes de réseaux mobiles publiées par l'ETSI/3GPP2 (UMTS, LTE) et par l'IEEE (Wi-Fi : IEEE 802.11) utilisent les dBm.

L'homme du métier appréciera, toutefois, qu'une valeur de puissance exprimée en dBm dépend de l'impédance de la charge considérée. Ainsi, dans le domaine de l'électroacoustique, une valeur exprimée en dBm se comprend généralement (sauf mention contraire) comme la puissance développée sur une charge normale d'impédance de 600 ohms (600 Ω). Une tension efficace de 0,775 volts produisant à très peu près 1 mW dans cette charge, cette valeur correspond au 0 dB. Mais dans le domaine radio, par exemple, une valeur en dBm se comprend comme la puissance développée sur une charge normale d'impédance égale à 50 ohms (50 Ω). Dans ce contexte, une tension efficace de 0,224 volts (224 mV) produisant à très peu près 1 mW dans cette charge, cette valeur correspond au 0 dB. En audio, les câbles normaux en paire torsadée ont une impédance caractéristique d'une centaine d'ohms. L'expression du niveau des seuils en dBm peut alors être ambiguë. Pour conserver le même niveau de référence en tension, sans référence à une charge, on peut indiquer le niveau en dBu, c'est-à-dire « x dB re 775 mV ». Dans les réalisations connues, les seuils minimum et maximum de la réponse du dispositif de CAG sont modifiés par l'algorithme auto-adaptatif associé à ce dispositif, en étant sont initialisés à des valeurs fixes déterminées. Or, ces valeurs sont difficiles à fixer étant donné que l'intervalle dynamique du signal reçu en entrée par le dispositif de CAG varie de manière significative, notamment en fonction du locuteur c'est-à-dire de la personne qui prononce le mot-clé d'activation à détecter.

On peut avoir un dispositif d'activation qui est :
- soit trop « sourd », c'est-à-dire qu'il présente beaucoup de « faux négatifs », l'utilisateur prononçant le mot-clé d'activation mais celui-ci n'étant pas reconnu car le seuil minimal Thₘᵢₙ est fixé à un niveau trop élevé ;
- soit trop « éveillé », c'est-à-dire qu'il présente beaucoup de « faux positifs », en ce sens que l'assistant personnel réagit même si l'utilisateur ne l'a pas sollicité, par ce que le seuil minimal Thₘᵢₙ est fixé à un niveau trop bas.

La fixation du seuil maximal Thₘₐₓ à un niveau inadapté peut aussi conduire à des problèmes de mauvaise détection du mot-clé d'activation se traduisant potentiellement par des faux positifs ou des faux négatifs. En effet, si le seuil Thₘₐₓ est fixé à un niveau trop bas, le signal en sortie du dispositif de CAG sature, et l'on perd une partie de l'information utile, c'est-à-dire du contenu de la parole prononcée par l'utilisateur. Inversement, si le seuil Thₘₐₓ est fixé à un niveau trop élevé, la dynamique du signal audio capté est repliée et l'on perd aussi en qualité du contenu de la parole, au détriment de la performance de la détection du mot-clé d'activation.

C'est pourquoi, dans des modes de réalisation de l'invention, on modifie le seuil minimal Thₘᵢₙ et/ou un seuil maximal Thₘₐₓ de la sensibilité de la détection de la voix qui sont définis par le dispositif de commande automatique de gain de tout ou partie des modules de détection du mot-clé d'activation, en fonction de l'identification d'un utilisateur présent dans le véhicule.

L'invention n'entend toutefois pas être limitée à ces exemples, car on peut également modifier d'autres paramètres de fonctionnement du dispositif de commande automatique de gain de ces modules de détection du mot-clé d'activation, à la place ou en plus du seuil minimal Thₘᵢₙ et/ou du seuil maximal Thₘₐₓ, comme par exemple la valeur du gain ou des seuils intermédiaires définissant des plages de variation plus restreintes de la réponse du dispositif dans l'intervalle dynamique d'entrée dudit dispositif.

Ainsi, d'une manière générale, les modes de réalisation permettent d'effectuer la calibration du dispositif de commande automatique de gain d'un ou plusieurs modules de détection du mot-clé d'activation avec des valeurs respectives d'un nombre *p* de paramètres de fonctionnement desdits dispositifs, où *p* est un nombre entier supérieur ou égal à l'unité, en fonction de l'indentification d'un utilisateur présent dans le véhicule. Les valeurs des paramètres concernées peuvent appartenir à un profil d'utilisateur associé à l'utilisateur détecté.

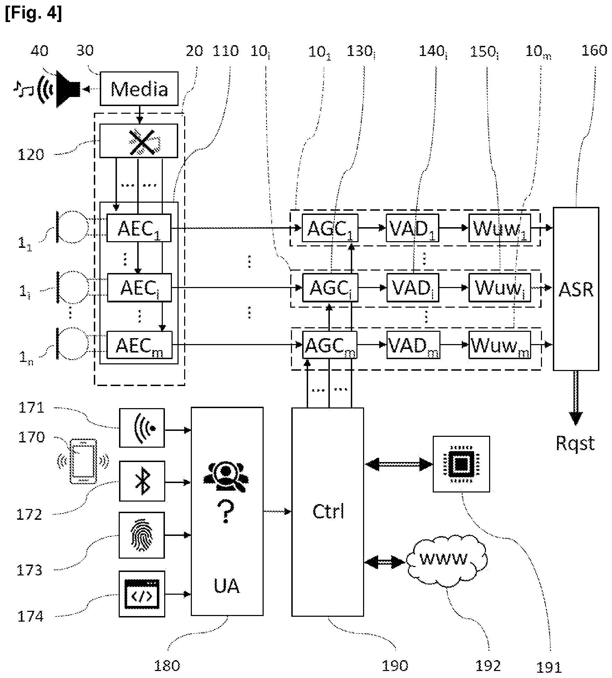

On va maintenant décrire l'achitecture d'un dispositif de détection du mot-clé d'activation de l'APV selon des premiers modes de réalisation, en référence au schéma de la **figure 4****.**

La **figure 4** montre schématiquement un dispositif selon des modes de réalisation, pour l'activation d'un assistant personnel virtuel dans un véhicule automobile par la voix d'un utilisateur.

Le dispositif comprend un nombre *m* de microphones 1₁ à 1ₘ, qui sont par exemple disposés chacun au niveau du siège de l'un du conducteur et des *m-1* passagers, dans le véhicule 101 de la figure 1, où *m* est un nombre entier supérieur ou égal à l'unité. Dit autrement, le dispositif comprend au moins un microphone.

Dans des modes de réalisation, le nombre *m* de microphones correspond au nombre de places assises dans le véhicule. Dit autrement, chacun des microphones 1₁ à 1ₙ est agencé pour capter plus particulièrement la voix de l'un déterminé des, au plus, *m* occupants du véhicule lorsqu'ils sont assis chacun à l'une des *m* places assises du véhicule.

Bien entendu, cependant, et en dépit de sa directivité, chacun des *n* microphones 1₁ à 1ₙ capte nécessairement la voix des autres occupants du véhicule lorsqu'ils parlent, et qui constitue du bruit vis-à-vis du signal audio visé par ledit microphone. Également, chaque microphone capte des bruits ambiants correspondant au fonctionnement du véhicule (bruit du moteur, bruit de roulage, bruit d'écoulement d'air, etc.). Enfin, il capte le son restitué dans l'habitacle du véhicule par un module média 30 du véhicule : le son de la radio, de la musique, la voix d'un interlocuteur distant participant à une communication téléphonique avec l'un des occupants du véhicule et qui est restituée par un haut-parleur 40 du véhicule dans le contexte d'un appel « mains libres », etc.

Le dispositif comprend aussi *m* modules d'anti-écho (ou AEC, de l'anglais « *Acoustic Echo Cancellation* ») AEC₁ à AECₘ, qui sont associés aux *m* microphones 1₁ à 1ₘ, respectivement. Dans l'exemple représenté à la figure 2, les modules AEC₁ à AEC, sont mis en oeuvre sous la forme de modules logiciels exécutés, par exemple, dans un processeur de signal numérique 110 (DSP), par exemple un DSP audio. De manière plus générale, le DSP 110 peut être adapté pour exécuter des modules de prétraitement des *m* signaux audio captés par les m microphones 1₁, 1₂, ..., 1ₘ, respectivement, dont les modules AEC₁ à AECₘ font partie.

Un DSP est similaire à un processeur normal mais, comme son nom l'indique, il est conçu pour fonctionner sur des signaux, par opposition à des données stockées en mémoire. Selon les applications, des signaux typiques sont des signaux audios, des signaux vidéo, des signaux radiofréquence (RF), etc., et de manière générale tous signaux qui arrivent au DSP via un convertisseur analogique-numérique (ADC, de l'anglais « *Analog-to-Digital Converter* »). Ces signaux sont traités via des méthodes de calcul tels que les transformées de Fourier rapides (ou FFT de l'anglais « *Fast Fourier Transform* ») ou des méthodes de calcul matriciel, pour les manipuler, les modifier (par exemple pour les filtrer) ou les analyser. En audio, cela peut être utilisé pour nettoyer un flux audio, y ajouter des effets, ou même générer de l'audio.

Dans des modes de réalisation, la fonction des modules d'anti-écho AEC₁ à AECₘ comprend, outre l'annulation d'écho comme leur nom l'indique, le fait de nettoyer le signal capté par chacun des microphones 1₁ à 1ₘ, respectivement, du signal média joué dans le véhicule. A cet effet, les modules d'anti-écho AEC₁ à AECₘ sont couplés à un module d'annulation de média 120 qui peut également être exécuté dans le DSP. Le module d'annulation de média 120 est lui-même couplé à un module de média 30 du véhicule pour recevoir un signal représentatif du son restitué dans le véhicule par ledit module de média 30 via le haut-parleur 40. Ainsi, l'annulation de ce son dans les signaux audio captés par les microphones 1₁ à 1ₘ et qui constitue du bruit vis-à-vis de la voix du locuteur visé, est particulièrement efficace.

D'autres modules de prétraitement, non représentés, peuvent être mis en oeuvre dans le DSP comme les modules 110 en étant adaptés pour exécuter un prétraitement de reconnaissance vocale (ou VRP, mis pour « *Voice Recognition Preprocessing* » en anglais). Dans des modes de réalisation, ce prétraitement de reconnaissance vocale comprend le fait de nettoyer les signaux audios captés par les m microphones 1₁ à 1ₘ, et déjà traités par les modules d'annulation d'écho AEC₁ à AECₘ, des bruits provenant du fonctionnement du véhicule ainsi que des bruits concurrents (y-compris, pour chaque signal audio associé à un occupant déterminé du véhicule, la voix des autres occupants du véhicule lorsqu'ils parlent).

Ainsi, grâce aux différents algorithmes de traitement de signal mis en oeuvre dans l'environnement du DSP, les fonctions de détection du mot-clé d'activation et de reconnaissance vocale qui sont ensuite exécutées dans le dispositif, et qui vont maintenant être décrites, sont robustes aux divers bruits dans le véhicule ainsi qu'aux bruits concurrents des autres occupants du véhicule.

Le dispositif comprend en effet un moteur de reconnaissance de la parole 160 (ou moteur ASR, où ASR est mis pour « *Automatic Speech Recognition* »), qui peut être un module logiciel exécuté dans le processeur principal (ou mCU, mis pour « *main Control Unit* » en anglais), du système IVI (mis pour « *In-vehicle Infotainment* ») du véhicule. La fonction du moteur de reconnaissance de la parole 160 est d'identifier une commande vocale prononcée par un utilisateur présent à bord du véhicule, par analyse de l'un déterminé des *m* signaux audio captés par les m microphones 1₁ à 1ₘ, respectivement.

Cette reconnaissance de la parole est précédée de la détection d'un mot-clé d'activation de l'APN, qui est réalisée par un module de détection de mot-clé d'activation. Dans l'exemple représenté, il y a un tel module 10₁ à 10ₘ pour chacun des *m* microphones 1₁ à 1ₘ, respectivement, agencés à bord du véhicule.

Ces modules 10₁ à 10ₘ peuvent également être des modules logiciels exécutés dans le processeur principal (mCU) précité du véhicule.

Ces modules de détection du mot-clé d'activation sont adaptés pour chercher, et le cas échéant détecter, le mot-clé d'activation de l'APV (comme « Ok google », « Alexa », ...) dans les *m* signaux audios captés par les *m* microphones 1₁ à 1ₘ, respectivement.

A cet effet, ils reçoivent chacun l'un desdits signaux audios, et exécutent en parallèle *m* moteurs de détection du mot-clé d'activation (ou moteur de Wuw) 150₁ à 150ₘ, respectivement. Dit autrement, les moteurs de détection du mot-clé d'activation 150₁ à 150ₘ sont appliqués, chacun, à l'un déterminé des signaux audios captés par les *m* microphones 1₁ à 1ₘ, respectivement. Afin de ne pas surcharger inutilement la figure, seul le moteur de Wuw 150i du module 10i (pour i compris entre 1 et *m*) est référencé à la figure 4.

D'un point de vue fonctionnel, un module de détection de mot-clé d'activation comme les modules 10₁ à 10ₘ peut être conçu comme un module séparable du moteur de reconnaissance vocale (ou moteur de ASR) proprement dit. Son moteur de détection de mot-clé d'activation 150₁ à 150ₘ peut être spécialement adapté pour permettre, à partir de l'un des *m* signaux audios captés par les *m* microphones 1₁ à 1ₘ, d'identifier la prononciation d'un mot-clé d'activation par un utilisateur dans le véhicule. Du point de vue de l'implémentation pratique, un moteur de détection de mot-clé d'activation 150₁ à 150ₘ peut être développé et fourni sous la forme d'un bloc de traitement, de nature logicielle, par un fournisseur spécifique comme par exemple *Nuance Communications, Inc., Qualcomm, Inc., Soundhound, Inc., Sensory, Inc.,* etc. Au sein de chacun des modules 10₁ à 10ₘ de détection du mot-clé d'activation, le moteur de détection de Wuw 150₁ à 150ₘ est précédé d'un module de détection d'activité vocale (ou VAD, de l'anglais « *Voice Activity Détection* ») 140₁ à 140ₘ, respectivement. Afin de ne pas surcharger inutilement la figure, seul le module de détection d'activité vocale 140i du module 10i (pour i compris entre 1 et *m*) est référencé à la figure 4.

En outre, chacun des modules 10₁ à 10ₘ de détection du mot-clé d'activation comprend, en amont du module de détection d'activité vocale 140₁ à 140ₘ, respectivement, un dispositif de commande automatique de gain (ou AGC) 130₁ à 130ₘ, respectivement. Afin de ne pas surcharger inutilement la figure, seul le dispositif de détection commande automatique de gain 130i du module 10i (pour i compris entre 1 et *m*) est référencé à la figure 4. Ces dispositifs 130₁ à 130ₘ sont des dispositifs comme le dispositif 21 décrit plus haut en référence à la figure 2 et à la figure 3. Le seuil Thₘᵢₙ de sensibilité minimale et leur seuil Thₘᵢₙ de sensibilité maximale sont paramétrables. On verra plus loin comment ces seuils Thₘᵢₙ et Thₘᵢₙ sont calibrés, selon des modes de réalisation de l'invention.

On notera au préalable que, dans un mode de réalisation, le module de reconnaissance de la parole 160 ne traite, avantageusement, qu'un seul des m signaux audios captés par les *m* microphones 1₁ à 1ₘ, respectivement. Plus particulièrement, il ne traite que celui de ces *m* signaux audios qui a été capté par le microphone associé à la place assise de la personne ayant prononcé le mot-clé d'activation, comme détecté par le module de détection du mot-clé d'activation correspondant parmi les modules 10₁ à 10ₘ. Ce signal est *a priori* celui parmi lesdits *m* signaux audios qui contient la meilleure représentation de la commande vocale prononcée, puisque cette commande vocale est prononcée par le même utilisateur que celui qui a prononcé le mot-clé d'activation. En effet, on rappelle que le principe est que l'utilisateur prononce la commande vocale à la suite du mot-clé d'activation.

Comme l'homme du métier l'aura compris, l'avantage de cette disposition est que le traitement par le module de reconnaissance de la parole 160 est limité à ce qui est nécessaire pour reconnaître et interpréter la commande ou la requête contenue dans un seul signal audio, à savoir celui qui contenait le mot-clé d'activation seulement. De plus, les échanges de données vers le module de reconnaissance de la parole 160 sont également limités au strict nécessaire, c'est-à-dire aux données du signal audio précité.

On appréciera que la disposition ci-dessus est avantageuse car elle limite la quantité des calculs mis en oeuvre dans le module de reconnaissance de la parole 150, mais n'est toutefois pas obligatoire. En effet, tous ou plusieurs des *m* signaux audio issus des *m* microphones 1₁ à 1ₘ, peuvent être transmis au module de reconnaissance de la parole 160, quelle qu'en soit la raison.

Le dispositif de la figure 2 comprend encore un module d'identification 180 qui a pour fonction de, et est adapté pour identifier un utilisateur du véhicule qui est potentiellement à l'origine de la commande vocale. Il peut s'agir d'un utilisateur préalablement enregistré comme étant un utilisateur potentiel du véhicule, en tant que conducteur et/ou en tant que passager du véhicule. Cet enregistrement préalable peut faire partie d'un processus de paramétrage de l'assistant personnel virtuel, mis en oeuvre en réponse à une commande d'un utilisateur, par exemple lors de l'achat du véhicule ou à tout autre moment par la suite.

L'identification d'un utilisateur peut être réalisée par tout moyen. Dans un premier exemple, l'identification de l'utilisateur peut résulter de la connexion au véhicule d'un appareil personnel 170 de l'utilisateur concerné, i.e., d'un appareil qui lui est personnellement associé, comme par exemple son téléphone portable. La connexion de cet appareil 170 au véhicule peut être physique (filaire) ou virtuelle (*i.e.,* sans fil). Elle peut être obtenue, par exemple, par un module 171 de connectivité Wi-Fi ou par un module 172 de connectivité Bluetooth (BT). Elle peut être réalisée, par exemple, automatiquement lorsque l'utilisateur monte à bord du véhicule avec son appareil dans la main, sur lui ou avec lui, par exemple dans un vêtement ou dans un sac. En variante, elle peut résulter du déclenchement d'une procédure de connexion à l'initiative de l'utilisateur, par exemple par appui sur un (ou plusieurs) bouton(s) du téléphone et/ou du véhicule, ou par tout autre moyen similaire. Quel que soit le moyen parmi les exemples non limitatifs ci-dessus, l'appareil personnel 170 étant associé de manière univoque à un utilisateur déterminé, il s'ensuit que l'identification de l'appareil 170 connecté au véhicule revient à l'identification de l'utilisateur. A la place d'un appareil communiquant, l'appareil 170 peut être un dispositif passif comme une clé intelligente ou une carte à puce, qui est associée de manière univoque à un utilisateur et qui contient à cet effet un code d'identification qui peut être lu par le module d'identification 180 de la figure 2.

En variante encore, l'identification d'un utilisateur peut être réalisée grâce à un capteur biométrique 173, comme un capteur d'empreinte digitale, ou tout dispositif similaire. Une information biométrique identifie de manière univoque un utilisateur déterminé, parmi un groupe d'utilisateurs potentiels connus du système à bord du véhicule. L'identification a lieu sur la base de la comparaison entre l'information biométrique obtenue par le capteur 173, avec des informations biométriques correspondantes, qui sont stockées dans une mémoire 191, parmi des informations définissant des profils d'utilisateurs associés aux utilisateurs potentiels du dispositif. Un tel profil d'utilisateur peut avoir été défini pour un utilisateur potentiel, par exemple, lors d'une phase préalable d'enregistrement dudit utilisateur potentiel.

Dans une autre variante, l'utilisateur s'identifie lui-même, par exemple en saisissant un code d'identification (ou identifiant) qui lui est personnellement associé, via une interface homme-machine (IHM) 174. Cette interface 174 peut comprendre, dans un exemple, un clavier virtuel sur un écran tactile du système d'info-divertissement du véhicule. A nouveau, cet identifiant peut être stocké dans la mémoire 191, parmi des informations définissant un profil d'utilisateur d'un utilisateur potentiel du véhicule qui a été enregistré en tant que tel.

En résumé, dans les modes de réalisation illustrés par le schéma de la figure 4, le module d'identification d'utilisateur 180 est adapté pour identifier un utilisateur présent dans le véhicule :
- indirectement sur la base de la connexion au véhicule d'un appareil électronique personnel 170 associé à l'utilisateur, via un dispositif d'interface comme le module 171 de connectivité Wi-Fi ou le module 172 de connectivité Bluetooth BT ; ou,
- directement sur la base d'une information biométrique associée à l'utilisateur obtenue par un capteur biométrique comme le capteur d'empreinte digitale 173; et/ou,
- directement sur la base d'un identifiant saisi par l'utilisateur via l'interface homme/machine 174 du système.

Le premier mode d'identification ci-dessus a l'avantage d'être transparent pour l'utilisateur : il ne s'occupe de rien et ne se rend d'ailleurs compte de rien, mais les dispositifs de commande automatique de gain 130₁-130ₘ des modules de détection du mot-clé d'activation 10₁-10ₘ peuvent être calibrés avec des valeurs de paramètres de fonctionnement qui lui correspondent. Inversement, les deux derniers modes d'identification ci-dessus nécessitent une action de l'utilisateur, mais l'avantage est que l'identification de l'utilisateur est certaine. Ces mises en oeuvre sont donc plus efficaces.

Le dispositif d'activation de l'APV comprend par ailleurs un module de calibration 190, qui est configuré pour calibrer le ou les modules de détection de mot-clé d'activation 10₁-10ₘ. Plus particulièrement, le module 190 est adapté pour calibrer les dispositifs de commande automatique de gain 130₁-130ₘ des modules de détection du mot-clé d'activation avec des valeurs respectives d'un nombre *p* de paramètres de fonctionnement desdits dispositifs, où *p* est un nombre entier supérieur ou égal à l'unité. Dit autrement, le module 190 est adapté pour calibrer au moins un paramètre de fonctionnement des dispositifs 130₁-130ₘ avec une valeur spécifique à ce paramètre. Cette valeur est fonction de l'utilisateur identifié par le module d'identification 180. Dans un exemple, c'est la même valeur pour tous les dispositifs 130₁-130ₘ, bien qu'elle puisse aussi être différente d'un de ces dispositifs à l'autre. Également, l'homme du métier appréciera que l'invention n'entend pas être limitée par le nombre de paramètre des dispositifs 130₁-130ₘ qui sont calibrés de cette manière.

Dans des modes de réalisation, les paramètres de fonctionnement des dispositifs de commande automatique de gain 130₁-130ₘ des modules de détection du mot-clé d'activation 10₁-10ₘ, respectivement, comprennent le seuil minimum Thₘᵢₙ et/ou le seuil maximum Thₘₐₓ de la sensibilité de la détection de la voix par les modules de détection du mot-clé d'activation 10₁-10ₘ. Dit autrement, l'un ou l'autre des seuils Thₘᵢₙ et Thₘₐₓ, ou les deux, sont calibrés par le module 190 avec des valeurs qui dépendent de l'utilisateur identifié par le module d'identification 180. Ceci permet d'ajuster l'intervalle dynamique d'entrée des dispositifs 130₁-130ₘ aux caractéristiques attendues des signaux audios captés par les microphones 1₁-1ₘ , respectivement, et donc d'augmenter les performances de détection du mot-clé d'activation par les moteurs de Wuw 150₁-150ₘ.

Dans un exemple de réalisation, les valeurs des paramètres de fonctionnement des dispositifs de commande automatique de gain 130₁-130ₘ des modules de détection du mot-clé d'activation 10₁-10ₘ qui sont utilisées pour la calibration appartiennent, pour tous ou pour partie des utilisateurs potentiels du véhicule, à un profil d'utilisateur associé audit utilisateur potentiel. Le ou les profils d'utilisateur du ou des utilisateurs potentiels du véhicule, respectivement, ou une partie d'entre eux au moins, peuvent être stockés dans une mémoire électronique installée dans le véhicule, comme par exemple la mémoire électronique 191 qui a déjà été présentée plus haut.

En variante, de tels profils d'utilisateur peuvent être stockés dans le cloud 192 et être accédés par des moyens de communication ad-hoc du véhicule. Le cas échéant, cet accès peut être réalisé via l'appareil électronique communiquant 170 de l'utilisateur, *i.e.,* via son téléphone portable dans un exemple.

Il va sans dire qu'en cas d'impossibilité d'identifier un utilisateur présent à bord du véhicule, et/ou en cas d'identification d'un utilisateur n'ayant pas de profil d'utilisateur enregistré ou dont le profil d'utilisateur enregistré ne comprend pas de valeurs des *p* paramètres de fonctionnement réglables des dispositifs de commande automatique de gain 130₁-130ₘ, la calibration de ces dispositifs peut être effectuée avec des valeurs par défaut pour ces paramètres. Ces valeurs par défaut correspondent par exemple à des valeurs médianes, qui ont par exemple été déterminées en laboratoire sur la base d'un échantillon d'utilisateurs témoins.

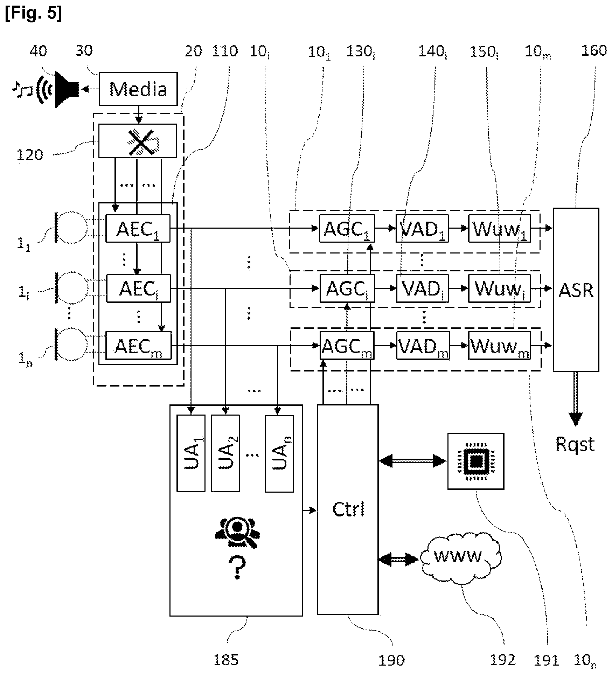

En référence maintenant au schéma fonctionnel de la **figure 5****,** le module d'identification d'utilisateur 180 de la figure 4 peut être remplacé par un module d'identification 185 adapté pour identifier un utilisateur présent dans le véhicule par analyse de tout ou partie des *m* signaux audios captés par les *m* microphones 1₁-1ₘ. Une telle identification peut être réalisée sur la base d'empreintes vocales associées aux utilisateurs potentiels du véhicule, qui sont stockées en mémoire en relation avec des profils d'utilisateurs associés à ces utilisateurs potentiels. Bien que cela ne soit pas symbolisé à la figure 5, ces empreintes vocales peuvent être stockées et lues dans la mémoire électronique 191, ou dans toute autre mémoire embarquée dans le véhicule. En variante, elles peuvent être stockées dans le cloud 192, et y être récupérées pour la mise en oeuvre de l'identification de l'utilisateur par le module 185.

Pour résumer, l'homme du métier appréciera que, dans le mode de réalisation de la figure 5, c'est directement la personne à l'origine de la commande vocale qui est identifiée par le module d'identification 185 sur la base d'empreintes vocales d'utilisateurs potentiels qui ont été enregistrées à l'avance. Ce mode de réalisation a l'avantage d'être direct, si bien que l'identification de l'utilisateur est certaine, tout en étant ici transparente pour l'utilisateur.

Quel que soit le mode d'identification de l'utilisateur (mode indirect ou mode direct), le déroulement de la détection d'un mot-clé d'activation de l'assistant personnel virtuel embarqué dans un véhicule automobile et activable par la voix d'un utilisateur, selon des modes de mise en oeuvre, comprenant les étapes suivantes. Tout d'abord, un nombre m de signaux audios respectifs, où *m* est un nombre entier supérieur ou égal à l'unité, sont captés à l'aide des *m* microphones 1₁-1ₘ agencés dans l'habitacle du véhicule. Ensuite, au sein des *m* modules 10₁-10ₘ de détection du mot-clé d'activation, les *m* moteurs 150₁-150ₘ de détection du mot-clé d'activation de l'assistant personnel virtuel sont exécutés en parallèle en étant appliqués à chacun, respectivement, des *m* signaux audios captés par les *m* microphones, respectivement. Parallèlement, ou préalablement, un utilisateur présent dans le véhicule est identifié au moyen du dispositif d'identification 180 de la figure 4 ou du dispositif d'identification 185 de la figure 5. Et les dispositifs de commande automatique de gain 130₁-130ₘ des modules 10₁-10ₘ de détection du mot-clé d'activation sont calibrés avec des valeurs respectives d'un nombre *p* de paramètres de fonctionnement desdits dispositifs, où *p* est un nombre entier supérieur ou égal à l'unité, lesdites valeurs étant fonction de l'utilisateur détecté. Dans un exemple, ces *p* paramètres comprennent l'un et/ou l'autre du seuil minimum Thₘᵢₙ et du seuil maximum Thₘₐₓ de la sensibilité de la détection de la voix par les modules de détection du mot-clé d'activation 10₁-10ₘ.

Un autre aspect de l'invention concerne un calculateur de véhicule automobile comprenant un processeur principal et/ou un processeur de signal numérique, configuré pour mettre en oeuvre le dispositif selon le premier aspect ci-dessus. Il peut s'agir, comme évoqué en introduction de la présente description, du calculateur qui gère l'info-divertissement à bord du véhicule (ou IVI, de l'anglais « *In-Vehicle Infotainment* »), qui gère les aspects média et les aspects communication dans le véhicule. Dans un exemple, le calculateur de processeur de signal numérique 20 met en oeuvre les modules 110 et 120, et le processeur principal 110 met en oeuvre les autres modules, à savoir les modules 130, 140, 150, 170 et 160, ainsi que les moteurs d'exécution 12 et 13. Ceci n'est toutefois qu'un exemple, et une autre répartition des fonctions entre le processeur 110 et le processeur 120 (ou d'autres processeurs additionnels) est possible. Inversement, le calculateur peut n'utiliser que le processeur principal 110, sans s'appuyer sur un processeur de signal numérique comme le processeur 120.

L'homme du métier appréciera que les modules de détection du mot-clé d'activation 10₁-10ₘ, et au sein d'eux les dispositifs de commande automatique de gain 130₁-130ₘ, les modules de détection d'activité vocale 140₁-140ₘ et les moteurs de détection du mot-clé d'activation 150₁-150ₘ, de même que le module d'identification 180 et le module de calibration 190 sont des entités purement fonctionnelles, distinguées à la figure 4 et à la figure 5 pour les seuls besoins de la clarté de l'exposé qui précède. En pratique toutefois, tous ou une partie au moins de ces éléments sont des éléments logiciels exécutés dans le calculateur qui met en oeuvre le dispositif, en sorte que le découpage au niveau du logiciel entre des éléments fonctionnels peuvent varier selon les spécificités propres à chaque implémentation. Par exemple, le module de calibration 190 peut être intégré au module d'identification d'utilisateur 180 ou aux modules de détection de mot-clé d'activation 130₁-130ₘ au niveau de la mise en oeuvre de ces modules sous la forme logicielle.

De manière générale, la présente invention a été décrite et illustrée dans la présente description détaillée et dans les figures des dessins annexés, dans des formes de réalisation possibles. La présente invention ne se limite pas, toutefois, aux formes de réalisation présentées. D'autres variantes et modes de réalisation peuvent être déduits et mis en oeuvre par la personne du métier à la lecture de la présente description et des dessins annexés.

Dans le présent exposé, le terme "comprendre" ou "comporter" n'exclut pas d'autres éléments ou d'autres étapes. Un seul processeur ou plusieurs autres unités peuvent être utilisées pour mettre en oeuvre l'invention. Les différentes caractéristiques présentées peuvent être avantageusement combinées. Leur présence dans des parties différentes, n'excluent pas cette possibilité. Les signes de référence ne sauraient être compris comme limitant la portée de l'invention.

## Revendications

1. Dispositif pour la détection d'un mot-clé d'activation d'un assistant personnel virtuel embarqué dans un véhicule automobile (101) et activable par la voix d'un utilisateur, comprenant :
- un nombre *m* de microphones (1₁-1ₘ), où *m* est un nombre entier supérieur ou égal à l'unité, agencés dans l'habitacle du véhicule automobile et adaptés pour capter *m* signaux audios respectifs ;
- *m* modules (10₁-10ₘ) de détection du mot-clé d'activation comprenant chacun un dispositif de commande automatique de gain (130₁-130ₘ), et adaptés pour exécuter en parallèle chacun un moteur (150₁-150ₘ) de détection du mot-clé d'activation de l'assistant personnel virtuel (104), lesdits moteurs de détection étant appliqués à chacun, respectivement, des *m* signaux audios captés par les m microphones, respectivement ;
- un module d'identification d'utilisateur (180) adapté pour identifier un utilisateur présent dans le véhicule ; et,
- un module de calibration (190) adapté pour calibrer les dispositifs de commande automatique de gain des modules de détection du mot-clé d'activation avec des valeurs respectives d'un nombre *p* de paramètres de fonctionnement desdits dispositifs, où *p* est un nombre entier supérieur ou égal à l'unité, lesdites valeurs étant fonction de l'utilisateur identifié par le module d'identification.

2. Dispositif selon la revendication 1, dans lequel les paramètres de fonctionnement des dispositifs de commande automatique de gain des modules de détection du mot-clé d'activation comprennent un seuil minimum (Thₘᵢₙ) et/ou un seuil maximum (Thₘₐₓ) de la sensibilité de la détection de la voix par les modules de détection du mot-clé d'activation.

3. Dispositif selon la revendication 1 ou la revendication 2, dans lequel des valeurs des paramètres de fonctionnement des dispositifs de commande automatique de gain des modules de détection du mot-clé d'activation appartiennent, pour chacun parmi un ou plusieurs utilisateurs potentiels du véhicule, à un profil d'utilisateur associé audit utilisateur potentiel.

4. Dispositif selon la revendication 3, dans lequel un profil d'utilisateur d'un utilisateur potentiel du véhicule est stocké dans une mémoire électronique (191) installée dans le véhicule.

5. Dispositif selon la revendication 3 ou la revendication 4, dans lequel un profil d'utilisateur d'un utilisateur potentiel du véhicule est stocké dans le cloud (192).

6. Dispositif selon l'une quelconque des revendication 1 à 5, dans lequel le module d'identification d'utilisateur (180) est adapté pour identifier un utilisateur présent dans le véhicule sur la base de :
- la connexion au véhicule d'un appareil électronique personnel (170) associé à l'utilisateur, via un dispositif d'interface (171,172) du véhicule ;
- une information biométrique associée à l'utilisateur obtenue par un capteur biométrique (173) du véhicule ; et/ou,
- un identifiant saisi par l'utilisateur via une interface homme/machine (174) du véhicule.

7. Dispositif selon l'une quelconque des revendication 1 à 5, dans lequel le module d'identification d'utilisateur (180) est adapté pour identifier un utilisateur présent dans le véhicule à l'origine de la commande vocale, par analyse de tout ou partie des *m* signaux audios captés par les *m* microphones, sur la base d'empreintes vocales stockées en mémoire en relation avec des profils d'utilisateurs associés à des utilisateurs potentiels du véhicule.

8. Procédé de détection d'un mot-clé d'activation d'un assistant personnel virtuel embarqué dans un véhicule automobile (101) et activable par la voix d'un utilisateur, comprenant les étapes consistant à :
- capter un nombre *m* de signaux audios respectifs, où m est un nombre entier supérieur ou égal à l'unité, à l'aide de *m* microphones (1₁-1ₘ) agencés dans l'habitacle du véhicule automobile ;
- exécuter en parallèle *m* moteurs (150₁-150ₘ) de détection d'un mot-clé d'activation de l'assistant personnel virtuel appliqués à chacun, respectivement, des *m* signaux audios captés par les *m* microphones, respectivement, à l'aide de *m* modules (10₁-10ₘ) de détection du mot-clé d'activation comprenant chacun un dispositif de commande automatique de gain (130₁-130ₘ) ;
- identifier un utilisateur présent dans le véhicule ; et,
- calibrer les dispositifs de commande automatique de gain des modules de détection du mot-clé d'activation avec des valeurs respectives d'un nombre *p* de paramètres de fonctionnement desdits dispositifs, où *p* est un nombre entier supérieur ou égal à l'unité, lesdites valeurs étant fonction de l'utilisateur identifié.

9. Calculateur de véhicule automobile comprenant un processeur principal (10) et/ou un processeur de signal numérique (20) configurés pour la mise en oeuvre du dispositif selon l'une quelconque des revendications 1 à 7.

10. Véhicule automobile (101) comprenant un calculateur selon la revendication 9.

## Patentansprüche

1. Vorrichtung zur Erkennung eines Aktivierungsschlüsselworts für einen virtuellen persönlichen Assistenten an Bord eines Kraftfahrzeugs (101), der durch die Stimme eines Benutzers aktivierbar ist, umfassend:
- eine Anzahl m von Mikrofonen (11-1m), wobei m eine ganze Zahl größer oder gleich Eins ist, die im Fahrgastraum des Kraftfahrzeugs angeordnet und dazu ausgelegt sind, m jeweilige Audiosignale aufzunehmen;
- m Aktivierungsschlüsselwort-Erkennungsmodule (101-10m), die jeweils eine automatische Verstärkungssteuervorrichtung (1301-130m) umfassen und dazu ausgelegt sind, parallel jeweils eine Worterkennungsmaschine (1501-150m) den Aktivierungsschlüssel (104) für den virtuellen persönlichen Assistenten auszuführen, wobei die Erkennungsmaschinen jeweils auf jedes der m Audiosignale angewendet werden, die jeweils von den m Mikrofonen aufgenommen werden;
- ein Benutzeridentifikationsmodul (180), das dazu geeignet ist, einen im Fahrzeug anwesenden Benutzer zu identifizieren; Und,
- ein Kalibrierungsmodul (190), das zum Kalibrieren der automatischen Verstärkungssteuerungsgeräte der Aktivierungsschlüsselworterkennungsmodule mit jeweiligen Werten einer Anzahl p von Betriebsparametern der genannten Geräte geeignet ist, wobei p eine ganze Zahl größer oder gleich eins ist, wobei diese Werte eine Funktion des durch das Identifizierungsmodul identifizierten Benutzers sind.

2. Vorrichtung nach Anspruch 1, bei der die Betriebsparameter der Vorrichtungen zur automatischen Verstärkungsregelung der Aktivierungsschlüsselworterkennungsmodule einen Mindestschwellenwert (Thmin) und/oder einen Höchstschwellenwert (Thmax) der Empfindlichkeit der Spracherkennung durch Aktivierungsschlüsselwort umfassen Erkennungsmodule.

3. Vorrichtung nach Anspruch 1 oder Anspruch 2, bei der Werte der Betriebsparameter der automatischen Verstärkungssteuerungsvorrichtungen der Aktivierungsschlüsselworterkennungsmodule für jeden von einem oder mehreren potenziellen Benutzern des Fahrzeugs zu einem Benutzerprofil gehören mit dem potenziellen Benutzer verbunden sind.

4. Vorrichtung nach Anspruch 3, bei der ein Benutzerprofil eines potentiellen Benutzers des Fahrzeugs in einem im Fahrzeug installierten elektronischen Speicher (191) gespeichert wird.

5. Vorrichtung nach Anspruch 3 oder Anspruch 4, wobei ein Benutzerprofil eines potenziellen Benutzers des Fahrzeugs in der Cloud (192) gespeichert ist.

6. Vorrichtung nach einem der Ansprüche 1 bis 5, bei der das Benutzeridentifikationsmodul (180) dazu ausgelegt ist, einen im Fahrzeug anwesenden Benutzer zu identifizieren auf der Grundlage von:
- die Verbindung eines dem Benutzer zugeordneten persönlichen elektronischen Geräts (170) mit dem Fahrzeug über eine Schnittstellenvorrichtung (171,172) des Fahrzeugs;
- dem Benutzer zugeordnete biometrische Informationen, die von einem biometrischen Sensor (173) des Fahrzeugs erfasst werden; und oder,
- eine vom Benutzer über eine Mensch-Maschine-Schnittstelle (174) des Fahrzeugs eingegebene Kennung.

7. Vorrichtung nach einem der Ansprüche 1 bis 5, bei der das Benutzeridentifikationsmodul (180) dazu ausgelegt ist, einen im Fahrzeug anwesenden Benutzer zu identifizieren, der den Sprachbefehl auslöst, indem es ein beliebiges oder einen Teil der m von ihm aufgenommenen Audiosignale analysiert die m-Mikrofone, auf der Grundlage von im Speicher gespeicherten Sprachabdrücken in Bezug auf Benutzerprofile, die potenziellen Benutzern des Fahrzeugs zugeordnet sind.

8. Verfahren zur Erkennung eines Aktivierungsschlüsselworts für einen virtuellen persönlichen Assistenten an Bord eines Kraftfahrzeugs (101), der durch die Stimme eines Benutzers aktivierbar ist, umfassend die Schritte bestehend aus:
- Erfassen einer Anzahl m jeweiliger Audiosignale, wobei m eine ganze Zahl größer oder gleich eins ist, unter Verwendung von m Mikrofonen (11-1m), die im Fahrgastraum des Kraftfahrzeugs angeordnet sind;
- paralleles Ausführen von m Engines (150₁-150ₘ) zum Erkennen eines Schlüsselworts zum Aktivieren des virtuellen persönlichen Assistenten, das jeweils auf jedes der m Audiosignale angewendet wird, die jeweils von den m Mikrofonen aufgenommen werden, unter Verwendung von m Modulen (101-10m) für Erfassen des Aktivierungsschlüsselworts, jeweils umfassend eine automatische Verstärkungskontrollvorrichtung (1301-130m);
- einen im Fahrzeug anwesenden Benutzer identifizieren; Und,
- Kalibrieren der Vorrichtungen zur automatischen Verstärkungsregelung der Aktivierungsschlüsselwort-Erkennungsmodule mit jeweiligen Werten einer Anzahl p von Betriebsparametern der genannten Vorrichtungen, wobei p eine ganze Zahl größer oder gleich Eins ist, wobei die genannten Werte eine Funktion davon sind identifizierter Benutzer.

9. Kraftfahrzeugcomputer, umfassend einen Hauptprozessor (10) und/oder einen digitalen Signalprozessor (20), der zur Implementierung der Vorrichtung nach einem der Ansprüche 1 bis 7 konfiguriert ist.

10. Kraftfahrzeug (101) umfassend einen Computer nach Anspruch 9.

## Claims

1. Device for the detection of a keyword activation of a virtual personal assistant embedded in a motor vehicle (101) and activated by the voice of a user, including:
- a *m* number of microphones (1₁-1ₘ), where m is a higher integer or equal to the unit, arranged in the passenger compartment of the motor vehicle and adapted to capture *my respective audio signals;*
- m modules (101-10m) for the detection of the activation keyword, each of which includes an automatic gain control device (1301-130m), and adapted to run in parallel each engine (150₁-150ₘ) for keyword detection activation of the virtual personal assistant (104), the said detection engines being applied to each, respectively, audio signals received by the m microphones, respectively;- a user identification module (180) adapted to identify a user present in the vehicle; and,
- a calibration module (190) adapted to calibrate the automatic gain control devices of the activation keyword detection modules with respective values of a number *p* of the operating parameters of the said devices, where *p* is an integer greater than or equal to the unit, the said values being the function of the user identified by the identification module.

2. A device according to Claim 1, in which the operating parameters of the automatic control devices for the gain of the activation keyword detection modules include a minimum threshold (_{Thmin}) and/or a maximum threshold (_{Thmax}) of the sensitivity of the detection of the voice by the activation keyword detection modules.

3. A device according to Claim 1 or Claim 2, in which values of the operating parameters of the automatic gain control devices of the activation keyword detection modules belong, for each of one or more potential users of the vehicle, to a user profile associated with that potential user.

4. A device according to Claim 3, in which a user profile of a potential user of the vehicle is stored in an electronic memory (191) installed in the vehicle.

5. A device according to Claim 3 or Claim 4, in which a user profile of a potential vehicle user is stored in the cloud (192).

6. A device according to any claim 1 to 5, in which the user identification module (180) is adapted to identify a user present in the vehicle on the basis of:
- the connection to the vehicle of a personal electronic device (170) associated with the user via a vehicle interface device (171,172);
- biometric information associated with the user obtained by a biometric sensor (173) of the vehicle; and/or
- an identifier entered by the user via a human/machine interface (174) of the vehicle.

7. A device according to any of the claims 1 to 5, in which the user identification module (180) is adapted to identify a user present in the vehicle which originated the voice control, by analyzing all or part of the audio signals received by *m* microphones, on the basis of voice fingerprints stored in memory in relation to user profiles associated with potential users of the vehicle.

8. Process for detecting a keyword for activating a virtual personal assistant embedded in a motor vehicle (101) and activated by the voice of a user, including the following steps:
- capture a number *m* of respective audio signals, where *m* is an integer greater than or equal to the unit, using *m* microphones (1₁-1ₘ₎ arranged in the passenger compartment of the motor vehicle;
- run in parallel m motors (150₁-150ₘ) to detect a keyword activation of the virtual personal assistant applied to each, respectively, audio signals received by m microphones, respectively, using m modules (101-10m) to detect the word - activation key including each an automatic gain control device (1301-130m);
- identify a user present in the vehicle; and,
- calibrate the automatic gain control devices of the activation keyword detection modules with respective values of a *p* number of operating parameters of the said devices, where *p* is an integer greater than or equal to the unit, the said values being a function of the user identified.

9. Motor vehicle calculator consisting of a main processor (10) and/or a digital signal processor (20) configured for the implementation of the device according to any of the claims 1 to 7.

10. Motor vehicle (101) including a calculator according to claim 9.
